# EUROPEAN PATENT SPECIFICATION

(11) **EP 0 509 614 B1**
(45) Date of publication and mention of the grant of the patent: **11.12.1996**
(21) Application number: 92201965.8
(22) Date of filing: 10.04.1991
(51) Int. Cl.: H01L 31/0224, H01L 31/068

(54) **Solar cell**
Solarzelle
Cellule solaire

(30) Priority: 13.04.1990 JP 98802/90
(43) Date of publication of application: 21.10.1992
(62) Divisional of application: 91303176.1
(73) Proprietor: MITSUBISHI DENKI KABUSHIKI KAISHA, Tokyo (JP); NIPPON TELEGRAPH AND TELEPHONE CORPORATION, Tokyo (JP)
(72) Inventor: Oohara, Takahiko, Higashimurayama-shi, Tokyo (JP); Ohmachi, Yoshiro, Higashiyamato-shi, Tokyo (JP); Kadota, Yoshiaki, Ebina-shi, Kanagawa-ken (JP); Mitsui, Kotaro, c/o Mitsubishi Denki K. K., 4-chome, Itami-shi, Hyogo-ken (JP); Ogasawara, Nobuyoshi, c/o Mitsubishi Denki K. K., 4-chome, Itami-shi, Hyogo-ken (JP); Nishimura, Takashi, c/o Mitsubishi Denki K. K., 4-chome, Itami-shi, Hyogo-ken (JP)
(74) Representative: Beresford, Keith Denis Lewis

(56) References cited:
- EP-A- 0 328 405
- PATENT ABSTRACTS OF JAPAN vol. 13, no. 181 (E-750)27 April 1989 & JP-A-1 008 612
- PATENT ABSTRACTS OF JAPAN vol. 13, no. 139 (E-738)6 April 1989 & JP-A-63 302 576
- PATENT ABSTRACTS OF JAPAN vol. 12, no. 500 (E-699)27 December 1988 & JP-A-63 211 774
- WPI/DERWENT 90-142634 c19! & JP-A-02-087669
- PATENT ABSTRACTS OF JAPAN Vol.13, No.307 (E-787), 13 July 1989 & JP-A-01-082572
- PATENT ABSTRACTS OF JAPAN Vol.13, No.272 (E-777), 22 June 1989 & JP-A-01-061958

## Description

The present invention relates to a GaAs solar cell on an Si substrate.

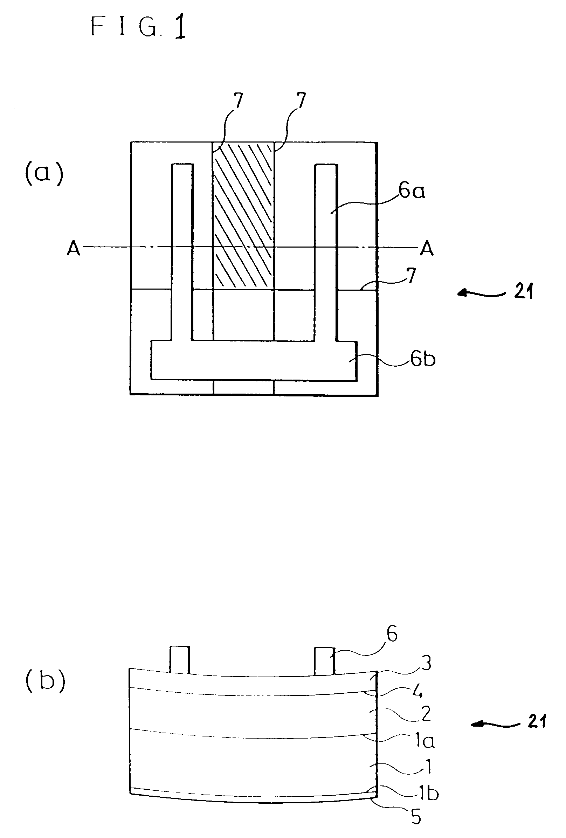

Figures 1(a) and 1(b) are views showing a structure of a conventional GaAs solar cell on an Si substrate, in which figure 1(a) is its plan view and figure 1(b) is a sectional view taken along a line A-A in figure 1(a). In figures 1(a) and 1(b), reference numeral 1 designates an Si substrate. A GaAs layer 2 of a first conductivity type, preferably n-type and a GaAs layer 3 of a second conductivity type (p-type) which serve as active layers are laminated on a first main surface 1a of the Si substrate 1 and then an anode electrode (p side electrode) 6 is formed on the p type GaAs layer 3 and a cathode electrode (n side electrode) 5 is provided on a second main surface 1b of the Si substrate 1. Thus, a solar cell 21 is formed.

The GaAs solar cell 21 on the Si substrate is normally manufactured by the following method.

First, the n type GaAs layer 2 and the p type GaAs layer 3 are sequentially formed on the first main surface 1a of the n type Si substrate 1 having a surface orientation of approximately (100) by a method of crystal growth of a compound semiconductor, such as MOCVD method. Thus, a pn junction 4 which generates a photovoltaic effect is formed. Then, as an electrode for taking a photoelectromotive force out, the anode electrode (p side electrode) 6 is selectively formed on the p type GaAs and the cathode electrode (n side electrode) 5 is formed on the whole surface of the second main surface 1b of the Si substrate 1. The anode electrode 6 comprises collecting electrodes 6a for collecting a photoelectric current and a common electrode 6b for connecting the collecting electrodes to an outside circuit. In addition, these electrodes are formed by sputtering or by vapour deposition and Ti/Ag is normally used.

It is a problem that, during thermal cycling, such as in performing a thermal shock test down to a temperature of -200°C, for example, cracks 7 can be generated.

The present invention, which is defined in the appended claims, is intended as a solution to the foregoing problem.

In the accompanying drawings:
Figure 1(a) is a plan view of a conventional GaAs solar cell on a Si substrate;
Figure 1(b) is a sectional view of this solar cell taken along a line A-A of figure 1(a);
Figure 2 is a sectional view of a GaAs solar cell on a Si substrate according to the present invention.

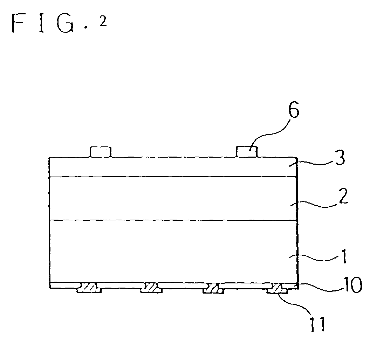

To further the understanding of this invention, a preferred embodiment thereof will be described hereinbelow and reference will be made to figure 2 of the drawings. The following description, however, is given merely by way of example.

According to the embodiment shown in figure 2, a non-conductive BN film 10 is provided on the second main surface of the Si substrate 1. Separate Ti/Au metal electrodes 11 formed over apertures in the BN film 10 are used as the n side electrodes 5. In this case, a compressive stress is applied to the GaAs layers 2 and 3 by the BN film 10 at a low temperature and then the tensile stress caused by the difference in thermal expansion coefficient between Si and GaAs can be offset. Thus, according to this embodiment of the present invention crack generation is suppressed.

Although the present invention has been described and illustrated in detail, it is clearly understood that the same is by way of illustration and example only and is not to be taken by way of limitation, the scope of the present invention being limited only by the terms of the following claims.

## Claims

1. A solar cell comprising:
a Si substrate (1) of a first conductivity type;
a first GaAs active layer (2) of a first conductivity type located on a front surface of said Si substrate (1);
a second GaAs active layer (3) of a second conductivity type located on, and defining a pn junction with, said first GaAs active layer (2);
a first electrode structure (11) in contact with the back surface of said Si substrate (1); and
a second electrode structure (6) in contact with said second GaAs active layer (3);
characterised in that
a non-conductive BN film (10) is formed on the back surface of said Si substrate (1), said first electrode structure (11) being in contact with the back surface of said Si substrate (1) via apertures in said BN film (10).

2. A solar cell as claimed in claim 1 wherein said first and second conductivity types are n-type and p-type respectively and said first electrode structure (11) is of metal.

3. A solar cell as claimed in claim 2 wherein said first electrode structure (11) is of Ti/Au.

## Patentansprüche

1. Solarzelle mit:
einem Si-Substrat (1) eines ersten Leitfähigkeitstyps;
einer ersten GaAs-Aktivschicht (2) eines ersten Leitfähigkeitstyps, die sich auf einer Front-Oberfläche des Si-Substrats (1) befindet;
einer zweiten GaAs-Aktivschicht (3) eines zweiten Leitfähigkeitstyps, die sich auf der ersten GaAs-Aktivschicht befindet und mit dieser einen p-n-Übergang definiert;
einer ersten Elektrodenstruktur bzw. -anordnung (11), die in Kontakt mit der rückwärtigen Oberfläche des Si-Substrats (1) steht; und
einer zweiten Elektrodenstruktur bzw. -anordnung (6), die in Kontakt mit der zweiten GaAs-Aktivschicht (3) steht;
dadurch gekennzeichnet, daß
ein nicht-leitender BN-Film (10) auf der rückwärtigen Oberfläche des Si-Substrats (1) ausgebildet ist, wobei die erste Elektrodenanordnung (11) über Öffnungen im BN-Film (10) in Kontakt mit der rückwärtigen Oberfläche des Si-Substrats (1) steht.

2. Solarzelle nach Anspruch 1, dadurch gekennzeichnet, daß die ersten und zweiten Leitfähigkeitstypen jeweils vom n-Typ und p-Typ sind, und daß die erste Elektrodenstruktur 11 aus Metall besteht.

3. Solarzelle nach Anspruch 2, dadurch gekennzeichnet, daß die erste Elektrodenstruktur (11) aus Ti/Au besteht.

## Revendications

1. Cellule solaire comprenant :
un substrat (1) en Si d'un premier type de conductivité ;
une première couche active (2) en GaAs d'un premier type de conductivité située sur une surface avant dudit substrat (1) en Si ;
une seconde couche active (3) en GaAs d'un second type de conductivité située sur ladite première couche active (2) en GaAs et définissant avec celle-ci une jonction pn ;
une première structure d'électrode (11) en contact avec la surface arrière dudit substrat (1) en Si ; et
une seconde structure d'électrode (6) en contact avec ladite seconde couche active (3) en GaAs ;
caractérisée en ce que
un film non conducteur (10) en BN est formé sur la surface arrière dudit substrat (1) en Si, ladite première structure d'électrode (11) étant en contact avec la surface arrière dudit substrat (1) en Si par l'intermédiaire d'ouvertures dans ledit film (10) en BN.

2. Cellule solaire comme revendiquée en revendication 1 dans laquelle les premier et second types de conductivité précités sont respectivement le type n et le type p et la première structure d'électrode (11) précitée est en métal.

3. Cellule solaire comme revendiquée en revendication 2 dans laquelle la première structure d'électrode (11) précitée est en Ti/Au.
